# EUROPEAN PATENT APPLICATION

(11) **EP 2 618 483 A1**
(43) Date of publication of application: **24.07.2013**
(21) Application number: 12290024.4
(22) Date of filing: 19.01.2012
(51) Int. Cl.: H03F 3/217, H03F 1/32

(54) **System and method for operating a switched mode amplifier**

(71) Applicant: NXP B.V., 5656 AG Eindhoven (NL)
(72) Inventor: Patrick, Jean, 14906 Caen Cedex 9 (FR); Vincent, Regnauld, 14906 Caen Cedex 9 (FR); Le Grontec, Alexis, Caen Cedex 9 14906 (FR)
(74) Representative: Krott, Michel

(57) **Abstract**

Various exemplary embodiments relate to a switched-mode amplifier. The amplifier may include a duty cycle controller, a switch connected to the duty cycle controller, and a feedback processor connected to the duty cycle controller. The duty cycle controller may be configured to modify the duty cycle of an input waveform based on information from the feedback processor. The switch may be turned on and off by a modified waveform from the duty cycle controller.

## Description

### TECHNICAL FIELD

Various exemplary embodiments disclosed herein relate generally to switched-mode amplifiers.

### BACKGROUND OF THE INVENTION

In a switched-mode amplifier, an input signal may be converted to a sequence of output pulses by turning a switch on and off. The output pulses may contain additional spectral components (i.e., the pulse frequency and its harmonics) which may be removed by a filter network. The resulting filtered signal may then be applied to a load.

### SUMMARY OF THE INVENTION

A brief summary of various exemplary embodiments is presented below. Some simplifications and omissions may be made in the following summary, which is intended to highlight and introduce some aspects of the various exemplary embodiments, but not to limit the scope of the invention. Detailed descriptions of a preferred exemplary embodiment adequate to allow those of ordinary skill in the art to make and use the inventive concepts will follow in later sections.

Various exemplary embodiments relate to a switched-mode amplifier, including: a duty cycle controller; a switch connected to the duty cycle controller; and a feedback processor connected to the duty cycle controller, wherein the duty cycle controller is configured to modify the duty cycle of an input waveform based on information from the feedback processor, and wherein the switch is turned on and off by a modified waveform from the duty cycle controller.

In some embodiments, the switched-mode amplifier further includes: a current sensor configured to detect the current consumption of the amplifier, wherein the information from the feedback processor is based on the detected current consumption from the current sensor. In some embodiments, the switched-mode amplifier further includes: a spectrum sensor configured to detect the spectrum of an amplified signal, wherein the information from the feedback processor is based on the detected spectrum from the spectrum sensor. In some embodiments, the switched-mode amplifier further includes: a duty cycle estimator configured to compare the duty cycle of the modified waveform from the duty cycle controller to a reference duty cycle, wherein the information from the feedback processor is based on a duty cycle signal from the duty cycle estimator.

In some embodiments, the switched-mode amplifier further includes: a current sensor configured to detect the current consumption of the amplifier; a spectrum sensor configured to detect the spectrum of an amplified signal; and a duty cycle estimator configured to compare the duty cycle of the modified waveform from the duty cycle controller to a reference duty cycle, wherein the information from the feedback processor is based on the detected current consumption from the current sensor, the detected spectrum from the spectrum sensor, and a duty cycle signal from the duty cycle estimator. In some embodiments, the input waveform is generated by phase-locked loop dividers. In some embodiments, the input waveform has an unstable duty cycle and the modified waveform from the duty cycle controller has a stable duty cycle. In some embodiments, the switched-mode amplifier further includes: a parasitic capacitance, wherein the duty cycle controller is configured to compensate for the parasitic capacitance by adjusting the duty cycle of the modified waveform. In some embodiments, the duty cycle controller is configured to generate the modified waveform by adjusting a charge time of a first capacitor and a charge time of a second capacitor. In some embodiments, the output power of the switched-mode amplifier is substantially constant between -50°C and 150°C.

Various exemplary embodiments further relate to a method for operating a switched-mode amplifier, including: receiving an input waveform having a first duty cycle; modifying the input waveform based on information from a feedback processor to produce a modified waveform having a second duty cycle; and controlling a switch with the modified waveform. In some embodiments, the method further includes: detecting the current consumption of the amplifier with a current sensor; and sending the detected current consumption from the current sensor to the feedback processor, wherein the information from the feedback processor is based on the detected current consumption from the current sensor. In some embodiments, the method further includes: detecting the spectrum of an amplified signal with a spectrum sensor; and sending the detected spectrum from the spectrum sensor to the feedback processor, wherein the information from the feedback processor is based on the detected spectrum from the spectrum sensor. In some embodiments, the method further includes: comparing the second duty cycle to a reference duty cycle with a duty cycle estimator; and sending a duty cycle signal from the duty cycle estimator to the feedback processor, wherein the information from the feedback processor is based on the duty cycle signal from the duty cycle estimator.

In some embodiments, the method further includes: detecting the current consumption of the amplifier with a current sensor; detecting the spectrum of an amplified signal with a spectrum sensor; comparing the second duty cycle to a reference duty cycle with a duty cycle estimator; sending the detected current consumption from the current sensor to the feedback processor; sending the detected spectrum from the spectrum sensor to the feedback processor; and sending a duty cycle signal from the duty cycle estimator to the feedback processor, wherein the information from the feedback processor is based on the detected current consumption, the detected spectrum, and the duty cycle signal. In some embodiments, the method further includes: generating the input waveform with phase-locked loop dividers. In some embodiments, the first duty cycle is unstable and the second duty cycle is stable. In some embodiments, the method further includes: compensating for a parasitic capacitance in the switched-mode amplifier by adjusting the second duty cycle. In some embodiments, the method further includes: adjusting a charge time of a first capacitor and a charge time of a second capacitor to produce the modified waveform. In some embodiments, the output power of the switched-mode amplifier is substantially constant between -50°C and 150°C.

### BRIEF DESCRIPTION OF THE DRAWINGS

In order to better understand various exemplary embodiments, reference is made to the accompanying drawings, wherein:
Fig. 1 illustrates an embodiment of a switched-mode amplifier;
Fig. 2 illustrates an alternate embodiment of a switched-mode amplifier;
Fig. 3 illustrates an example embodiment of a duty cycle controller;
Fig 4 illustrates an example of the relationship of the duty cycle of a switching signal to output power; and
Fig. 5 illustrates an example of the relationship between source voltage and output power at a variety of temperatures.

### DETAILED DESCRIPTION OF THE DRAWINGS

Referring now to the drawings, in which like numerals refer to like components or steps, there are disclosed broad aspects of various exemplary embodiments.

The power and efficiency of switched-mode amplifiers may vary with the load, temperature, parasitic capacitance, and/or other system properties of the amplifier. Conventional approaches to improve the power and efficiency of a switched-mode amplifier may include tuning the output load circuit to compensate for extra capacitances, or modifying the PCB layout to reduce the capacitance at the amplifier output. The conventional approaches may require significant time and expertise to implement, and may require redesign each time a different PCB is utilized. Therefore, there is a need for a switched-mode amplifier that does not require precise overall system design for each different application.

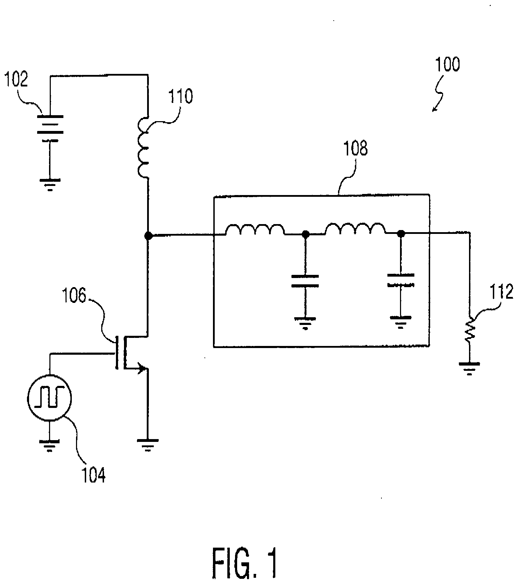

Fig. 1 illustrates an embodiment of a switched-mode amplifier 100. The amplifier 100 may include a DC power supply 102, a waveform generator 104, a switch transistor 106, a matching network 108, a supply inductor 110, and a load 112. The power supply 102 may be connected to the supply inductor 110, and the supply inductor 110 may be connected to the drain of the switch transistor 106 and to the matching network 108. The matching network 108 may be connected to the load 112, and the load may be connected to ground. The matching network 108 may include capacitors, inductors, resistors, and/or other circuitry that may produce desired frequency characteristics and/or impedance characteristics. The source of the switch transistor 106 may be connected to ground. The gate of the switch transistor 106 may be connected to the waveform generator 104. The waveform input by the waveform generator 104 may determine when the switch transistor 106 is turned on and off.

The efficiency and power of the amplifier 100 may be determined by the switch transistor 106, the matching network 108, and the waveform input by the waveform generator 104.

The structure and size of the switch transistor 146 may be constrained by the maximum operating voltage and the hybrid time constant (Rₒₙ * C_{off}) of the switch transistor 106. The maximum operating voltage and the hybrid time constant may depend on the characteristics of the IC process used to manufacture the switch transistor 106. The choice of switch transistor 106 may be determined by a desired power and operating frequency of the amplifier 100. By considering the operating conditions of the amplifier 100 and the capabilities of the IC process used to manufacture the transistor, an optimal switch transistor 106 may be included in the amplifier 100. Therefore, a change in the switch transistor 106 may not improve the performance of the amplifier 100, and modifications to the switch transistor 106 may not be considered when an improvement in the efficiency and power of the amplifier 100 is desired.

In theory, the matching network 108 may be designed to allow the amplifier 100 to achieve a desired power and efficiency. However, when implementing the matching network 108, additional considerations may affect the theoretically designed matching network 108. For example, a parasitic capacitance may be added at the amplifier 100 output from such structures as ESD protections, package leads and footprints, and PCB tracks. As a result, efficiency and power may differ significantly from the theoretical design, and improving the efficiency and power of the amplifier 100 by modifying the matching network 108 may be difficult.

The waveform input by the waveform generator 104 has two characteristics that may determine power and efficiency of the amplifier 100. The characteristics are the slew-rates (rising and falling edges) and the duty cycle of the input waveform. The slew-rate may impact the efficiency of the amplifier 100; however inefficiencies in the slew-rate may be easily overcome by properly designing the driver stage of the amplifier 100. The duty cycle of the input waveform may impact the efficiency, output power, and harmonic content of the output signal. The input waveform may be generated by phase-locked loop (PLL) dividers. The PLL dividers that generate the input waveform may not produce a proper nominal value or a stable duty cycle for the desired range of frequency bands, temperatures, and supply voltages. As a result, efficiency and power may differ significantly from the theoretical design. However, the duty cycle of the waveform from the PLL dividers may be modified to improve the efficiency and power of the amplifier 100.

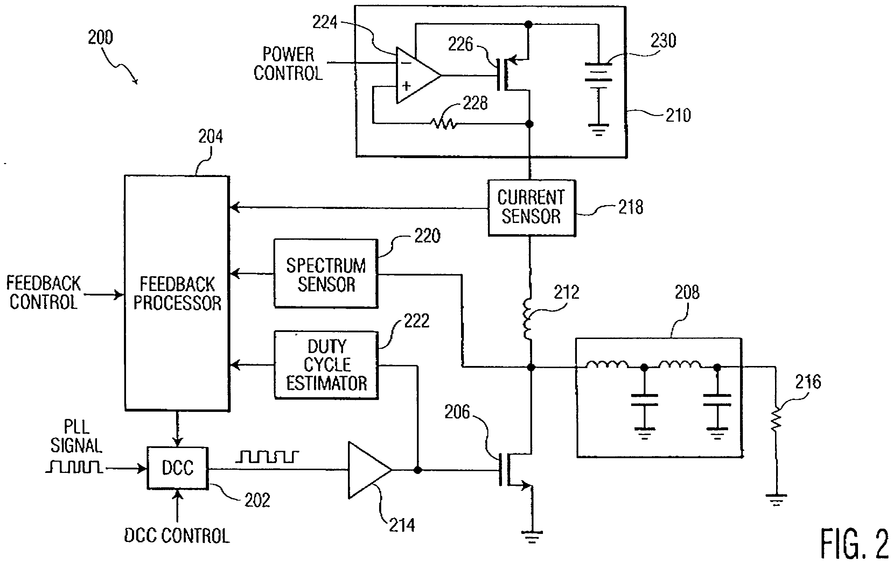

Fig. 2 illustrates an alternate embodiment of a switched-mode amplifier 200. The amplifier 200 may include a duty cycle controller (DCC) 202, a feedback processor 204, a switch transistor 206, a matching network 208, power supply circuitry 210, a supply inductor 212, a driver 214, a load 216, a current sensor 218, a spectrum sensor 220, and a duty cycle estimator 222. The matching network 208 may include capacitors, inductors, resistors, and/or other circuitry that may produce desired frequency characteristics and/or impedance characteristics.

The power supply circuitry 210 may include an op amp 224, a supply transistor 226, a biasing resistor 228, and power source 230. The op amp 224 may receive a power control signal from a controller (not shown). The power control signal may enable/disable the supply transistor 226. When the supply transistor 226 is enabled, the power source 230 may supply power to the amplifier 200 and the amplifier 200 may be enabled. When the supply transistor 226 is disabled, the power source 230 may be isolated from the amplifier 200, and the amplifier 200 may be disabled.

The DCC 202 may receive a PLL signal from PLL circuitry (not shown) and a DCC control signal from a controller (not shown). The PLL signal may not have a stable duty cycle or a proper nominal value over the frequency bands, temperature, and supply voltage of the amplifier 200. The DCC control signal may enable/disable the DCC 202 and/or control the operation of the DCC 202. When the DCC 202 is enabled, the DCC 202 may modify the input PLL signal to have an adjustable and stable duty cycle. When the DCC 202 is disabled, the input PLL signal may pass through the DCC 202 without modification. The DCC 202 may further receive a signal from the feedback processor 204. The signal from the feedback processor 204 may control the operation of the DCC 202 when the DCC 202 is enabled and configured to receive control signals from the feedback processor 204. The signal output from the DCC 202 when the DCC 202 is enabled may be a waveform with an adjustable and stable duty cycle. The waveform output from the DCC 202 may be amplified or buffered by the driver 214, and input to the gate of the switch transistor 206. This waveform may be a switching signal that determines when the switch transistor 206 is turned on and off.

The feedback processor 204 may receive a feedback control signal from a controller (not shown). The feedback control signal may enable/disable the feedback processor 204 and/or control the operation of the feedback processor 204. The feedback processor 204 may further receive signals from the current sensor 218, spectrum sensor 220, and/or duty cycle estimator 222. The feedback processor 204 may receive signals from other types of sensors and monitoring devices, such as, for example, temperature sensors. The feedback processor 204 may use the signals from the current sensor 218, spectrum sensor 220, duty cycle estimator 222, and/or other sensors and monitoring devices to instruct the DCC 202 how to modify the PLL signal.

The current sensor 218 may detect variation in the current consumption of the amplifier 200. The current consumption may vary as the load impedance changes due to parasitic capacitances in the amplifier 200. The feedback processor 204 may instruct the DCC 202 to modify the PLL signal so that the variation in the current consumption as detected by the current sensor 218 is minimized.

The spectrum sensor 220 may detect the spectrum of the signal at the drain of the switch transistor 206. The spectrum sensor may determine the strength of the fundamental frequency and of each harmonic that constitutes the signal at the drain of the switch transistor 206. The feedback processor 204 may instruct the DCC 202 to modify the PLL signal so that the spectral content of the signal at the drain of the switch transistor 206 is at a desired level. For example, the DCC 202 may modify the PLL signal so that the second harmonic of the signal at the drain of the switch transistor 206 is minimized.

The duty cycle estimator 222 may compare the duty cycle of the signal output by the driver 214 to a reference duty cycle. The feedback processor 204 may instruct the DCC 202 to modify the PLL signal so that the duty cycle of the signal output by the driver 214 is more similar to the reference duty cycle.

The feedback processor 204 may utilize one or more of the signals from the current sensor 218, spectrum sensor 220, and duty cycle estimator 222 to optimize the power and efficiency of the amplifier 200.

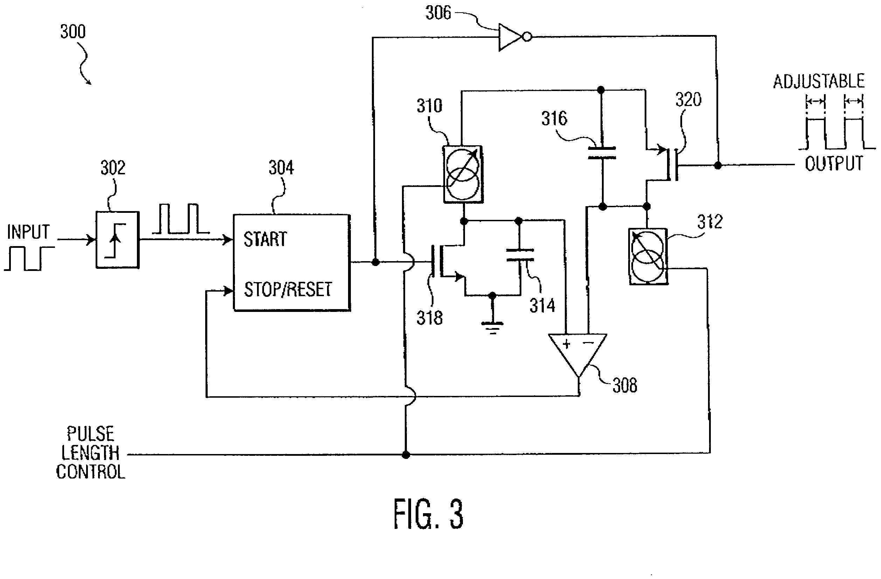

Fig. 3 illustrates an example embodiment of a duty cycle controller (DCC) 300. The DCC 300 may include a pulse generator 302, a controller 304, an inverter 306, an op amp 308, a first variable current source 310, a second variable current source 312, a first capacitor 314, a second capacitor 316, a NMOS transistor 318, and a PMOS transistor 320.

The pulse generator 302 may generate a short pulse from an input waveform. The controller 304 may receive the short pulse and may output a "low" signal. The "low" signal may disable the NMOS transistor 318. The "low" signal may be converted to a "high" signal by the invertor 306. The "high" signal may disable the PMOS transistor 320. Disabling the NMOS and PMOS transistors 318 and 320 may cause the first and second capacitors 314 and 316 to begin charging. The first and second capacitors 314 and 316 may continue charging until their charges are equal. When the first and second capacitors' 314 and 316 charges are equal, the controller 304 may be reset by receiving a reset signal from the op amp 308. When the controller 304 is reset, the first and second capacitors 314 and 316 may stop charging until another short pulse is received by the controller 304. The time elapsed between the start and stop may create an output pulse with an adjustable and stable duty cycle. The time it takes for the first and second capacitors 314 and 316 to charge may be adjusted by varying the DC charge current. The DC charge current may be varied by the first and second variable current sources 310 and 312. The first and second variable current sources 310 and 312 may be varied by a pulse length control signal from a controller (not shown). The pulse length control signal may vary the first and second variable current sources 310 and 312 so that the output pulse has a desired duty cycle.

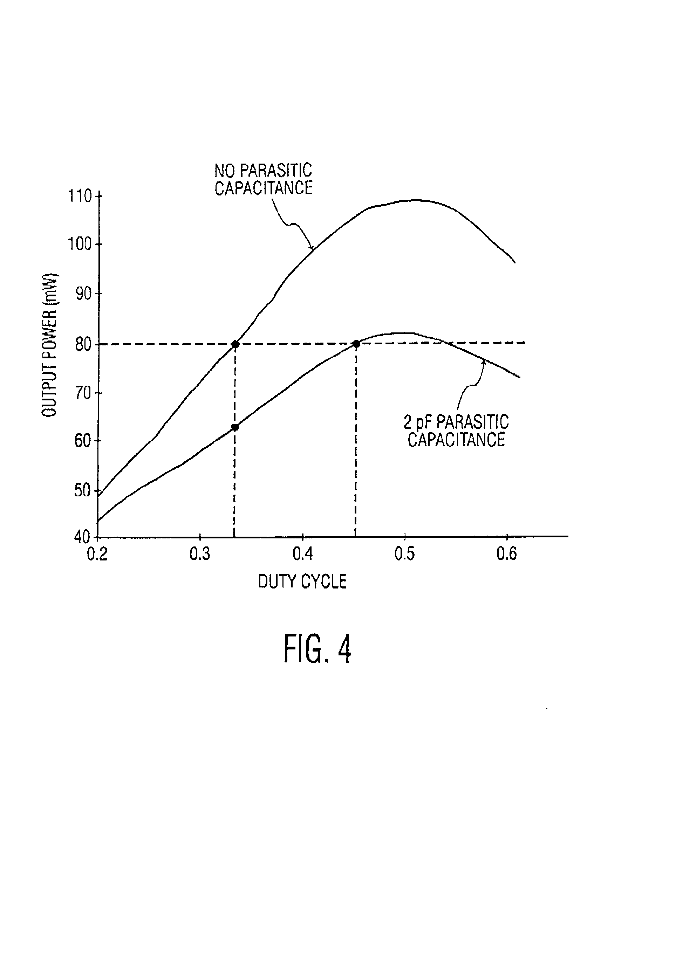

In a conventional switched-mode amplifier, parasitic capacitances in the amplifier may reduce the output power. With the addition of the DCC 202 as shown in Fig. 2, the output power may be increased by modifying the duty cycle of the switching signal. Fig 4 illustrates an example of the relationship of the duty cycle of the switching signal to the output power. In the example illustrated in Fig. 4, the amplifier may have an ideal output power of 80mW with no extra parasitic capacitances at a duty cycle of 0.34. With the addition of a parasitic capacitance of, for example, 2pF, the output power may drop to 62mW at the duty cycle of 0.34. However, by increasing the duty cycle to 0.45, the output power may be increased back to 80mW. The parasitic capacitances in the amplifier 200 may vary with the load, temperature, or other system properties. However, the DCC 202 may allow the amplifier 200 to maintain a constant output power as the parasitic capacitance varies by adjusting the duty cycle of the switching signal.

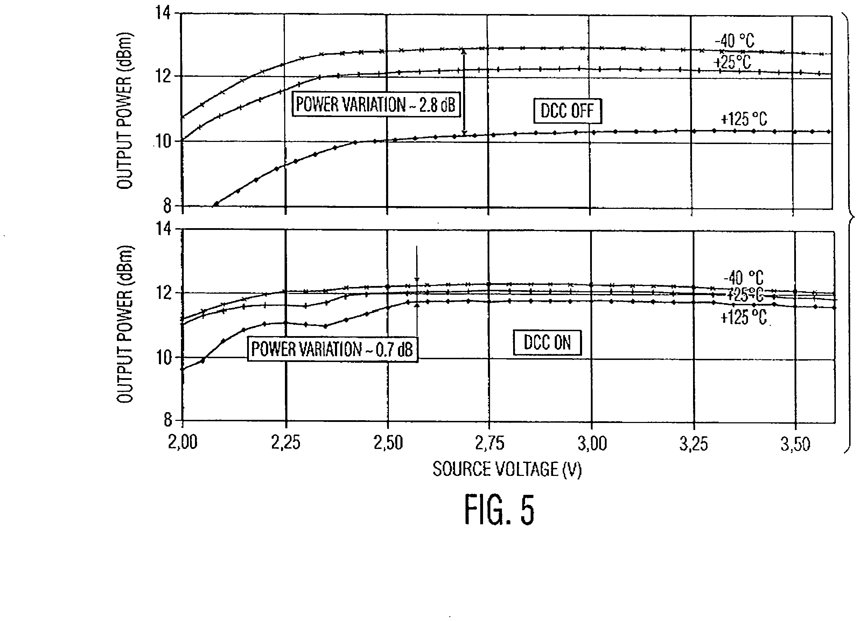

In a conventional switched-mode amplifier, the duty cycle of the switching signal may fluctuate with variations in temperature. This is because the circuitry generating the PLL signal may be sensitive to temperature. The variations in temperature may cause the output power of the amplifier to vary significantly. Fig. 5 illustrates an example of the relationship between the voltage from power source 230 and the output power at a variety of temperatures. The upper graph in Fig. 5 illustrates an example of the power output of the switched-mode amplifier 200 with the DCC 202 disabled. With the DCC 202 disabled, the output power may vary by approximately 2.8 dB as the temperature fluctuates between -40°C and 125°C. The lower graph in Fig. 5 illustrates an example of the power output of the switched-mode amplifier 200 with the DCC 202 enabled. With the DCC 202 enabled, the output power may vary by approximately 0.7 dB as the temperature fluctuates between -40°C and 125°C. By utilizing the DCC 202, the amplifier 200 may maintain a substantially constant output power over a large range of temperatures.

It should be appreciated by those skilled in the art that any block diagrams herein represent conceptual views of illustrative circuitry embodying the principals of the invention. Similarly, it will be appreciated that any flow charts, flow diagrams, state transition diagrams, pseudo code, and the like represent various processes which may be substantially represented in machine readable media and so executed by a computer or processor , whether or not such computer or processor is explicitly shown.

Although the various exemplary embodiments have been described in detail with particular reference to certain exemplary aspects thereof, it should be understood that the invention is capable of other embodiments and its details are capable of modifications in various obvious respects. As is readily apparent to those skilled in the art, variations and modifications can be affected while remaining within the spirit and scope of the invention. Accordingly, the foregoing disclosure, description, and figures are for illustrative purposes only and do not in any way limit the invention, which is defined only by the claims.

## Claims

1. A switched-mode amplifier, comprising:
a duty cycle controller;
a switch connected to the duty cycle controller; and
a feedback processor connected to the duty cycle controller,
wherein the duty cycle controller is configured to modify the duty cycle of an input waveform based on information from the feedback processor, and wherein the switch is turned on and off by a modified waveform from the duty cycle controller.

2. The switched-mode amplifier of claim 1, further comprising:
a current sensor configured to detect the current consumption of the amplifier,
wherein the information from the feedback processor is based on the detected current consumption from the current sensor.

3. The switched-mode amplifier of claim 1, further comprising:
a spectrum sensor configured to detect the spectrum of an amplified signal,
wherein the information from the feedback processor is based on the detected spectrum from the spectrum sensor.

4. The switched-mode amplifier of claim 1, further comprising:
a duty cycle estimator configured to compare the duty cycle of the modified waveform from the duty cycle controller to a reference duty cycle,
wherein the information from the feedback processor is based on a duty cycle signal from the duty cycle estimator.

5. The switched-mode amplifier of claim 1, further comprising:
a current sensor configured to detect the current consumption of the amplifier;
a spectrum sensor configured to detect the spectrum of an amplified signal;
and
a duty cycle estimator configured to compare the duty cycle of the modified waveform from the duty cycle controller to a reference duty cycle,
wherein the information from the feedback processor is based on the detected current consumption from the current sensor, the detected spectrum from the spectrum sensor, and a duty cycle signal from the duty cycle estimator.

6. A method for operating a switched-mode amplifier, comprising:
receiving an input waveform having a first duty cycle;
modifying the input waveform based on information from a feedback processor to produce a modified waveform having a second duty cycle; and
controlling a switch with the modified waveform.

7. The method of claim 6, further comprising:
detecting the current consumption of the amplifier with a current sensor; and
sending the detected current consumption from the current sensor to the feedback processor,
wherein the information from the feedback processor is based on the detected current consumption from the current sensor.

8. The method of claim 6, further comprising:
detecting the spectrum of an amplified signal with a spectrum sensor; and
sending the detected spectrum from the spectrum sensor to the feedback processor,
wherein the information from the feedback processor is based on the detected spectrum from the spectrum sensor.

9. The method of claim 6, further comprising:
comparing the second duty cycle to a reference duty cycle with a duty cycle estimator; and
sending a duty cycle signal from the duty cycle estimator to the feedback processor,
wherein the information from the feedback processor is based on the duty cycle signal from the duty cycle estimator.

10. The method of claim 6, further comprising:
detecting the current consumption of the amplifier with a current sensor;
detecting the spectrum of an amplified signal with a spectrum sensor;
comparing the second duty cycle to a reference duty cycle with a duty cycle estimator;
sending the detected current consumption from the current sensor to the feedback processor;
sending the detected spectrum from the spectrum sensor to the feedback processor; and
sending a duty cycle signal from the duty cycle estimator to the feedback processor,
wherein the information from the feedback processor is based on the detected current consumption, the detected spectrum, and the duty cycle signal.

11. The amplifier of claim 1 or the method of claim 6, wherein:
the input waveform is generated by phase-locked loop dividers.

12. The amplifier of claim 1 or the method of claim 6, wherein in the case of the amplifier the input waveform has an unstable duty cycle and the modified waveform from the duty cycle has a stable duty cycle, and in the base of the method, the first duty cycle is unstable and the second duty cycle is stable.

13. The amplifier of claim 1 or the method of claim 6, further comprising:
in the case of the amplifier, a parasitic capacitance, the duty cycle controller being configured to compensate for the parasitic capacitance by adjusting the duty cycle of the modified waveform, and in the case of the method, compensating for the parasitic capacitance in the switched-mode amplifier by adjusting the second duty cycle.

14. The amplifier of claim 1 or the method of claim 6, wherein:
in the case of the amplifier, the duty cycle controller is configured to generate the modified waveform by adjusting a charge time of a first capacitor and a charge time of a second capacitor, and in the case of the method, the method further comprises adjusting the charge time of the first capacitor and the charge time of the second capacitor to produce the modified waveform.

15. The amplifier of claim 1 or the method of claim 6, wherein the output power of the switched-mode amplifier is substantially constant between -50°C and 150°C.
